# EUROPEAN PATENT APPLICATION

(11) **EP 4 044 771 A1**
(43) Date of publication of application: **17.08.2022**
(21) Application number: 21157487.6
(22) Date of filing: 16.02.2021
(51) Int. Cl.: H05B 6/12, H05K 7/20

(54) **HOUSEHOLD APPLIANCE**

(71) Applicant: Electrolux Appliances Aktiebolag, 105 45 Stockholm (SE)
(72) Inventor: ROBLES, Antonio, 33170 Pordenone PN (IT); PAOLINI, Claudio, 47100 Forli (IT)
(74) Representative: Electrolux Group Patents

(57) **Abstract**

The present invention is related to a household appliance (10) comprising an electric load consuming electrical energy and a supply unit (14) for supplying the electric load with electrical energy. The supply unit (14) comprises
- a circuit board accommodating an electronic circuit, which includes electronic components (18, 20),
- at least one power electronic component (20) included in the electronic circuit, which power electronic component (20) is heated up during its operation, and
- a cooling fan (24, 24') configured for blowing cooling air towards the at least one power electronic component (20) in order to generate a cooling effect.

According to the invention, the supply unit (14) comprises a universal positioning space and preferably a universal fastening means (34, 36). The universal positioning space and preferably the universal fastening means (34, 36) is or are configured for the use of optionally a first type or a second type of a cooling fan (24, 24') in the supply unit (14).

## Description

The present invention relates to a household appliance comprising an electrical load and a supply unit according to the preamble of claim 1.

Generally, household appliances are assembled from modular components, which may be individual parts, e.g. motors, heating elements, pumps, or the like, or systems or subsystems. In production facilities not only one model of a particular type of a household appliance is manufactured. In fact, different models including different specific components or subsystems are provided in order to meet different requirements of users or to provide different models with different structural options for different application fields. It is a frequent practice to rely on a common platform, which allows the manufacturing of different models by modifying the use of at least one component.

It is an object of the present invention to provide a household appliance, which provides an increased flexibility in the production of different models of the household appliance, specifically in order to allow the production of models with different geometric dimensions.

The object is achieved for a household appliance according to the preamble of claim 1 by the features of the characterizing part of claim 1.

A household appliance comprising an electric load consuming electrical energy, in particular a heating element of the household appliance, and a supply unit for supplying the electric load with electrical energy, in particular a power board, wherein the supply unit comprises
- a circuit board accommodating an electronic circuit, which includes electronic components,
- at least one power electronic component, in particular an electronic switch, included in the electronic circuit, which power electronic component is heated up during its operation, and
- a cooling fan configured for blowing cooling air towards the at least one power electronic component in order to generate a cooling effect,

According to the present invention, the supply unit comprises a universal positioning space, wherein the universal positioning space is configured for the use of optionally a first type or a second type of cooling fan in the supply unit.

The household appliance is particularly a cooking appliance and may be a cooking hob, in particular an electrically driven cooking hob. A specifically selected appliance is an induction cooking hob.

Preferably, the supply unit also comprises a universal fastening means for the fixation of an element of the supply unit. Particularly, said fastening means is a screw and a screw hole, specifically configured for receiving a screw that fastens the element to the supply unit. Also the universal fastening means may contribute to allow the use of optionally the first type or the second type of cooling fan in the supply unit.

Advantageously, the first and second types of cooling fans include various designs and/or various sizes. Moreover, the first and second types of cooling fans may include blowing mechanisms that are different from each other. The different blowing mechanism may be provided by an axial fan, on the one hand, and a radial fan, on the other hand. The different fan types, notably due to their different blowing mechanisms, usually entail different blowing powers. Axial fans may provide higher blowing power than radial fans. On the other hand, radial fans may stand out with respect to lower design height compared to axial fans. It may be therefore advantageous to make use of an axial fan, if the overall height of the household appliance makes this choice possible.

The universal positioning space for the cooling fan may be arranged on the circuit board or on a carrier plate for the supply unit. It may be favourable to position the cooling fan on the circuit board, what may reduce the dependency on tolerances, particularly if the cooling fan has to be connected to components on the circuit board. On the other hand, the arrangement of the cooling fan on a carrier plate for the supply unit, which is preferably also a carrier plate for the circuit board, may be less expensive, because there is no need to reserve the respective space on the circuit board, therein saving circuit board material.

A specific embodiment provides for a suction opening, which is arranged in the circuit board and/or in the carrier plate for the intake of suction air. Said suction opening is preferably positioned in the area of the universal positioning space. More preferably, the suction opening is arranged in a central area of the universal positioning space, particularly in the case of a central air intake.

A particularly preferred embodiment of the household appliance is characterized by a supply unit, which comprises or is configured to receive an adapter housing configured for redirecting airflow. Said redirection particularly takes place from a vertical direction into a horizontal direction, specifically in connection with an air intake through any kind of horizontal support plate for the adapter housing or for a cooling fan, which support plate may be the circuit board or the carrier plate, as mentioned above.

According to embodiments, the adapter housing is used in combination with the use of an axial fan. This may correlate with a use of a radial fan without any airflow redirection, notably without the combination with an adapter housing, particularly when a fan housing of the implemented radial fan already cares for such redirection, e. g. with a vertical air intake and a horizontal blow-out.

The universal positioning space and the universal fastening means may be configured for either attaching a radial fan, particularly a housing of a radial fan, or for attaching the adapter housing. That way, a cooking hob model "A" may be equipped with a radial fan on the assembly line, particularly without any additional adapter housing since the cooking hob structure equipped with said radial fan is a "standard" structure. In particular, as indicated above, this cooking hob structure is characterized by a comparably low design height. The radial fan of cooking hob model "A" is positioned on the universal positioning space. Alternatively, a cooking hob model "B" may be equipped with the adapter housing by positioning it on the universal positioning space instead of the radial fan of model "A". A related cooling fan in cooking hob model "B" is then alternatively implemented, as will be described further down below by way of possible solutions.

One embodiment provides for an inlet opening of the adapter housing, which is adapted to be positioned over the suction opening. Alternatively, any intermediate channel between the suctioning opening and the inlet opening may be provided.

The cooking hob design, specifically the design of its supply unit, may be characterized by an implementation of an axial fan, which is arranged in an orientation for an air-blowing in vertical direction, wherein the redirected airflow pertains to the air exiting from the axial fan. To this end, the axial fan may be implemented in, or upstream of, the inlet opening of the adapter housing.

It may, alternatively, be preferred, however, to implement the axial fan arranging it in an orientation for an air-blowing in horizontal direction, wherein the redirected airflow pertains to the incoming air, i. e. the axial fan not only blows out the cooling air in horizontal direction, but also the incoming air streams in the inlet opening of the axial fan in horizontal direction. In order to realize such horizontal air supply of the axial fan, the air flowing through the suction opening of the carrier plate or the circuit board in vertical direction is redirected by the adapter housing, which is arranged in particular upstream of the axial fan.

One specific embodiment of the present invention provides for the at least one power electronic component being arranged in or on a cooling channel, which is arranged on the circuit board and which is configured for guiding the airflow of the cooling air, i. e. the airflow blown out from the cooling fan of whichever type. Said specific embodiment is characterized in that the geometric design of the cooling channel is selectable in dependence on the selection of the type of cooling fan. If particularly an axial fan is implemented, notably arranged in the orientation of horizontally blowing out the cooling air, what may mean that the axial fan is in upright position, the outlet opening of this axial fan is notably of a higher vertical extension than when using a radial fan, so that the types of cooling channels related to either the axial fan or to the radial fan may differ in their vertical extensions in the same way.

Finally, a particularly preferred embodiment of the present invention is characterized by an implementation of an axial fan, which is arranged at or in an end section of the adapter housing or between an outlet port of the adapter housing and an inlet port of the cooling channel. The inlet port of the cooling channel may be directly adjoin the outlet opening of the axial fan. Preferably, however, the inlet port of the cooling channel and the outlet opening of the axial fan are distantly located from each other, specifically in order to provide a structure-borne sound isolation.

Novel and inventive features of the present invention are set forth in the appended claims.

The present invention will be described in further detail with reference to the drawings, in which
- Fig. 1: illustrates schematically a perspective top view of an induction cooking hob including two power boards;
- Fig. 2: is a perspective view of one of the power boards according to Fig. 1 forming a first solution for providing power electronic components with cooling air;

- Fig. 3: is a perspective view of a solution for a power board used as an alternative to the power board according to Fig. 2 forming a second solution for providing power electronic components with cooling air; and
- Fig. 4: is a schematic illustration of the component group for the provision of cooling air for the second solution according to Fig. 3, with an adapter housing in transparent illustration.

In all figures the same or equivalent part are marked with the same reference numbers.

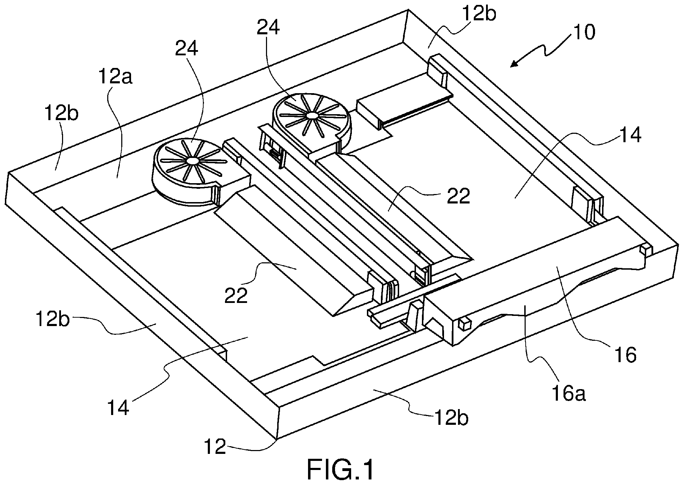

Fig. 1 illustrates schematically the design of an induction cooking hob 10.

The induction cooking hob 10 comprises a casing 12 including a bottom wall 12a, four side walls 12b and an open top side. Preferably, the casing 12 is made of metal, e.g. steel. Alternatively, the casing 12 may be made of plastics. A panel (not shown), which may be a glass ceramic panel, covers the top side of the casing 12.

On said panel, cooking zones are defined, which cooking zones are supplied with controllable heating power for heating up cookware placed thereon. Each cooking zone receives its heating power from a heating element (not shown) arranged beneath the panel. Said heating element is an induction coil, which is supplied with electrical power by means of a power board 14 of the induction cooking hob 10 arranged below the heating elements. The arrangement according to Fig. 1 shows two power boards 14 arranged adjacent to each other above the bottom wall 12a of the casing 12. Each power board 14 is configured for supplying two induction coils with electrical power, so that the cooking hob 10 according to Fig. 1 provides four cooking zones.

The cooking hob 10 further comprises a user interface 16 for enabling user inputs including also a control panel for controlling the cooking hob functions. Generally, the user interface 16 includes touch sensors and display means corresponding with a user interface zone that may be arranged at a front edge of the panel, particularly the glass panel, which detail, however, are not shown in Fig. 1. In fact, the user interface 16 is merely indicated as being arranged on a user interface carrier 16a, which is supported against the bottom wall 12a of the casing 12.

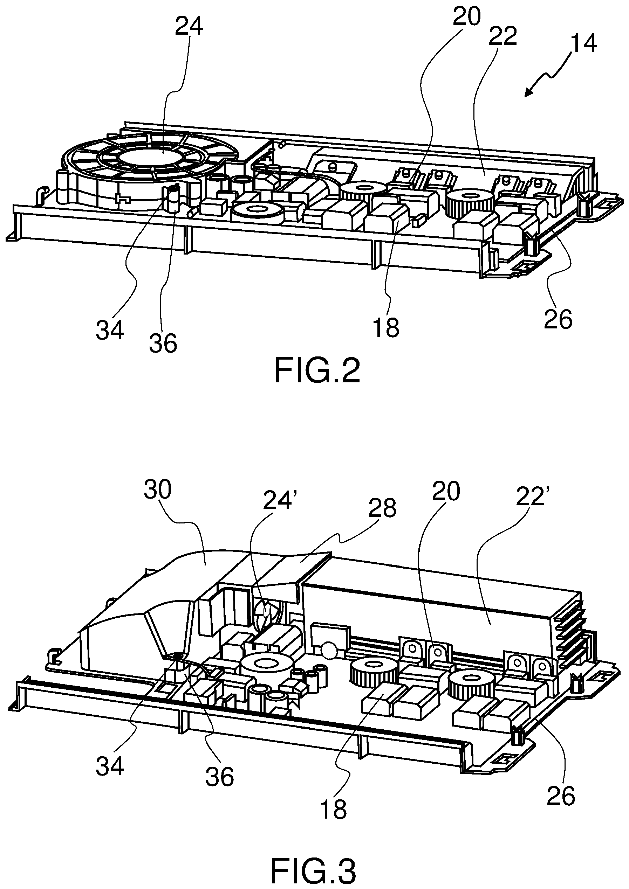

As can be seen in more detail in Fig. 2, which shows one of the power boards 14 according to Fig. 1 in a perspective view, each power board 14 is formed by a printed circuit board including a plurality of electric and/or electronic components 18, 20. Power electronic elements 20 for supplying the induction coils with electrical power are attached to a cooling channel 22, which extends horizontally through the cooking hob 10 and is arranged on the circuit board next to one of the longer lateral edges. An air stream driven by a cooling fan 24 passes the cooling channel 22 and cools down the power electronic elements 20 during their operation.

The structure of the power board 14 according to Figs. 1 and 2 is characterized by a flat construction, so that the overall height of the induction cooking hob 10 can be kept comparably low. This allows the implementation of this type of cooking hob 10 in a kitchen environment with e. g. comparably high base cabinets, so that the storage space in this kitchen environment can be kept large. A contributory factor for the flat hob construction is particularly a flat design of the cooling fan 24, which in the solution according to Figs. 1 and 2 is a radiant fan 24. The radiant fan 24 is characterized by a central air intake from below a carrier plate 26 in a vertical airflow direction and an air output exiting from an outlet tangentially arranged at a flat fan housing, wherein the output airflow is provided in horizontal direction.

Another power board design is shown in Fig. 3, which illustrates a second solution for providing the power electronic components 20 on the power board 14 with cooling air. While the general design of the circuit board of this second solution is more or less the same as in the first solution according to Figs. 1 and 2, the cooling air system is different. Instead of the radiant fan 24 in Figs. 1 and 2, the second solution operates with an axial fan 24' arranged in an upright orientation upstream the cooling channel 22' for the power electronic components 20. Said cooling channel 22' of Fig. 3 differs from the cooling channel 22 of the first solution in its geometric dimensions. Essentially its construction height is notably increased compared to that one of the cooling channel 22 illustrated in Figs. 1 and 2. This increased height results in a larger cross-sectional area adapted to provide a passage for the higher airflow volume provided by the axial fan 24'. Between axial fan 24' and cooling channel 22' a funnel-shaped air guide panel 28 is arranged, having a lateral opening towards the circuitry of the power board 14 for a partial cooling air discharge.

Due to the fact that the air intake is identical in both solutions, i. e. an air intake from below the carrier plate 26 with a vertical airflow direction, and the fact that the axial fan 24' includes a horizontal suction aperture, a redirection of the air intake is needed. To this end, an adapter housing 30 is arranged directly upstream the axial fan 24', which adapter housing 30 is positioned at the same place as the housing of the radial fan 24 of the first solution. The adapter housing 30 is essentially characterized by an inlet opening directed downwards, by an outlet opening directed sideways and by a curved upper surface, which ascends towards the outlet opening of the adapter housing 30.

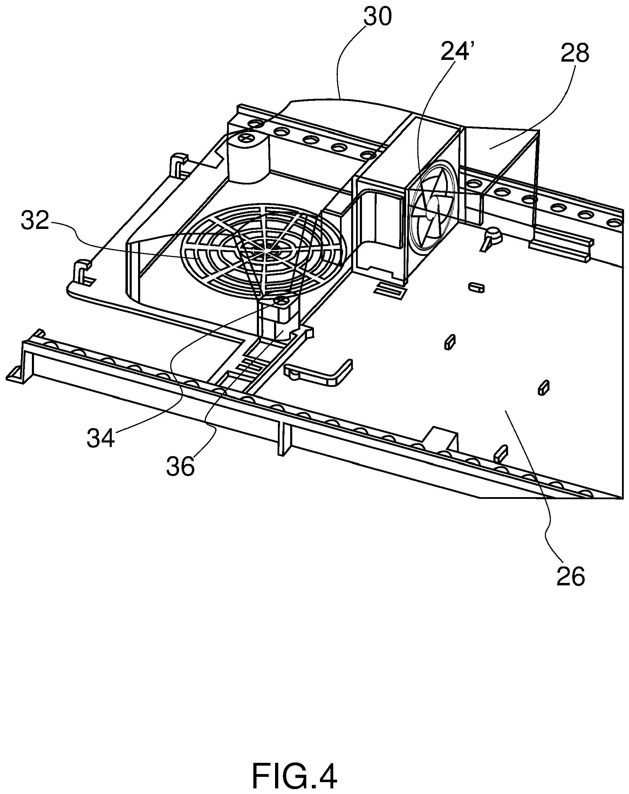

Fig. 4 illustrates schematically the component group for the provision of cooling air for the second solution according to Fig. 3, with the adapter housing 30 in transparent illustration for providing a better understanding of its mode of action. Also a housing for the axial fan 24' and the funnel-shaped air guide panel 28 is transparently shown. Due to the transparent illustration, the universal suction opening 32 for either the radial fan 24 or the adapter housing 30 is visible. Moreover, due to the omission of the circuit board in Fig. 4 the common carrier plate 26 used for both the first solution and the second solution can be seen.

It be pointed out again, the common universal positioning space in both solutions is a material aspect. While in the solution according to Figs. 1 and 2 the universal positioning space accommodates the radial fan 24, the same positioning space is reserved for the adapter housing 30 in the second solution. Further, independently from the implemented unit, the fastening thereof is realized by one and the same universal fastening means, which is a couple of a screw 34 and an associated screw hole 36, wherein two of these couples are in a diametrically opposed arrangement at the housing of the radial fan 24.

Although illustrative embodiments of the present invention have been described herein with reference to the accompanying drawings, it is to be understood that the present invention is not limited to these precise embodiments, and that various other changes and modifications may be affected therein by one skilled in the art without departing from the scope or spirit of the invention. All such changes and modifications are intended to be included within the scope of the invention as defined by the appended claims.

### List of reference numerals

- 10: induction cooking hob
- 12: casing
- 12a: bottom wall
- 12b: side walls
- 14: power boards
- 16: user interface
- 16a: user interface carrier
- 18, 20: electric / electronic components
- 22, 22': cooling channel
- 24, 24': cooling fans
- 26: carrier plate
- 28: air guide panel
- 30: adapter housing
- 32: suction opening
- 34: screw
- 36: screw hole

## Claims

1. A household appliance (10), particularly a cooking appliance, more particularly a cooking hob, even more particularly an induction cooking hob, comprising an electric load consuming electrical energy, in particular a heating element, and a supply unit (14) for supplying the electric load with electrical energy, in particular a power board, wherein the supply unit (14) comprises
- a circuit board accommodating an electronic circuit, which includes electronic components (18, 20),
- at least one power electronic component (20), in particular an electronic switch, included in the electronic circuit, which power electronic component (20) is heated up during its operation, and
- a cooling fan (24, 24') configured for blowing cooling air towards the at least one power electronic component (20) in order to generate a cooling effect,
**characterized in that**
the supply unit (14) comprises a universal positioning space and preferably a universal fastening means (34, 36), in particular a screw and a screw hole, wherein the universal positioning space and preferably the universal fastening means (34, 36) being configured for the use of optionally a first type or a second type of a cooling fan (24, 24') in the supply unit (14).

2. The household appliance (10) according to claim 1,
**characterized in that**
the first and second types of cooling fans (24, 24') include various designs and/or various sizes.

3. The household appliance (10) according to claim 1 or 2,
**characterized in that**
the first and second types of cooling fans (24, 24') include different blowing mechanisms, in particular provided by an axial fan (24') and a radial fan (24).

4. The household appliance (10) according to anyone of the preceding claims,
**characterized in that**
the universal positioning space for the cooling fan (24, 24') is arranged on the circuit board or on a carrier plate (26) for the supply unit (14).

5. The household appliance (10) according to anyone of the preceding claims,
**characterized in that**
a suction opening (32) is arranged in the circuit board and/or in the carrier plate (26) for the intake of suction air, preferably in the area, more preferably in a central area, of the universal positioning space.

6. The household appliance (10) according to anyone of the preceding claims,
**characterized in that**
the supply unit (14) comprises or is configured to receive an adapter housing (30) configured for redirecting an airflow, in particular from a vertical direction into a horizontal direction.

7. The household appliance (10) according to claim 6,
**characterized in that**
the adapter housing (30) is used in combination with the use of an axial fan (24').

8. The household appliance (10) according to claim 6 or 7,
**characterized in that**
the universal positioning space and universal fastening means (34, 36) are configured for either attaching a radial fan (24), particularly a housing of a radial fan (24), or attaching the adapter housing (30).

9. The household appliance (10) according to claim 5 and anyone of the claims 6 to 8,
**characterized in that**
an inlet opening of the adapter housing (30) is adapted to be positioned over the suction opening (32).

10. The household appliance (10) according to anyone of the claims 6 to 9,
**characterized by**
an implementation of an axial fan (24'), which is arranged in an orientation for an air-blowing in vertical direction, wherein the redirected airflow pertains to the air exiting from the axial fan (24').

11. The household appliance (10) according to anyone of the claims 6 to 9,
**characterized by**
an implementation of an axial fan (24'), which is arranged in an orientation for an air-blowing in horizontal direction, wherein the redirected airflow pertains to the incoming air.

12. The household appliance (10) according to anyone of the preceding claims,
**characterized in that**
the at least one power electronic component (20) is arranged in or on a cooling channel (22, 22'), which is arranged on the circuit board of the power board (14) and configured for guiding the airflow of the cooling air, wherein the geometric design of the cooling channel (22, 22') is selectable in dependence on the selection of the type of cooling fan (24, 24').

13. The household appliance (10) according to claim 12 when depending on anyone of the claims 6 to 11,
**characterized by**
an implementation of an axial fan (24'), which is arranged at or in an end section of the adapter housing (30) or between an outlet port of the adapter housing (30) and an inlet port of the cooling channel (22, 22').
